# EUROPÄISCHE PATENTSCHRIFT

(11) **EP 1 119 903 B1**
(45) Veröffentlichungstag und Bekanntmachung des Hinweises auf die Patenterteilung: **29.05.2002**
(21) Anmeldenummer: 99969857.4
(22) Anmeldetag: 27.09.1999
(51) Int. Cl.: H03D 7/14

(54) **SCHALTUNGSANORDNUNG ZUM MISCHEN EINES EINGANGSSIGNALS UND EINES OSZILLATORSIGNALS MITEINANDER**
CIRCUIT FOR MIXING AN INPUT SIGNAL AND AN OSCILLATOR SIGNAL WITH EACH OTHER
CIRCUITERIE POUR MELANGER UN SIGNAL D'ENTREE ET UN SIGNAL D'OSCILLATEUR

(30) Priorität: 30.09.1998 DE 19844970
(43) Veröffentlichungstag der Anmeldung: 01.08.2001
(73) Patentinhaber: Infineon Technologies AG, 81669 München (DE)
(72) Erfinder: CATALA, Stephane, D-85737 Ismaning (DE)
(74) Vertreter: Fischer, Volker, Dipl.-Ing.
(86) Internationale Anmeldenummer: DE9903102
(87) Internationale Veröffentlichungsnummer: WO0019599

(56) Entgegenhaltungen:
- EP-A- 0 434 203
- EP-A- 0 714 163
- EP-A- 0 774 832
- EP-A- 0 853 374

## Beschreibung

Die Erfindung betrifft eine Schaltungsanordnung zum Mischen eines Eingangssignals und eines Oszillatorsignals miteinander.

Spiegelfrequenzunterdrückungsmischer sind eine vorteilhafte Lösung, um aufwendige Spiegelfrequenzunterdrückungsfilter bei Eingangsempfängern einzusparen und um eine höhere Integration zu erreichen. Jedoch haben derartige Mischer den Nachteil, daß sie mehr als das doppelte der Leistung eines üblichen Mischers benötigen. Die Frage der Leistungsaufnahme ist insbesondere bei mobilen Anwendungen von großer Bedeutung, da die Leistungsaufnahme dort im wesentlichen die Kostenintensität, den Aufbau des jeweiligen Gerätes und dessen Eigenschaften wesentlich beeinflußt.

Beispielsweise aus den Patentschriften US 4,801,900 und US 5,661,485 sind Signalfrequenzunterdrückungsmischer bekannt. Derartige Mischer umfassen in der Regel einen Eingangsverstärker mit geringem Rauschen, zwei identische Mischstufen mit einem jeweils damit in Verbindung stehenden Verstärker für ein Oszillatorsignal, einen Phasenteiler zum Erzeugen zweier orthogonaler Oszillatorsignale aus den ursprünglichen Oszillatorsignal und einen Ausgangsphasenkombinierer. Dabei spielen die Eingangs- und Ausgangsimpedanzverhältnisse eine besondere Rolle. Eine mehr oder weniger hohe Eingangsimpedanz bei den Verstärkern für das Oszillatorsignal bedeutet üblicherweise eine höhere Leistungsaufnahme. Darüber hinaus muß die Einfügungsdämpfung aufgrund dieser zusätzlichen Elemente durch den Phasenkombinierer am Ausgang kompensiert werden, was wiederum eine höhere Leistungsaufnahme nach sich zieht. Übliche Verstärker mit geringem Rauschen werden aufgebaut als Leistungs-Spannungs-Umsetzer mit einem eingangsseitigen Transistor (oder Transistorpaar bei differenzieller Ausführung) in Kaskodenschaltung, der bzw. das eine passive Last wie etwa ein paralleles Tiefpaßnetzwerk mit Widerständen und Kondensatoren treibt. Eine Spannung-Strom-Rückkopplung mit einem Widerstand benötigt eine genau abgestimmte Eingangsimpedanz, um die geforderte Linearität zu erreichen. Zwar sind Eingänge mit gemeinsamen Emittern am besten geeignet für niedriges Rauschen, diese müssen allerdings mit einem sehr hohen Biasstrom (einige mA) betrieben werden. Das Leistungssignal am Eingang wird also in einen Strom umgewandelt, der die passive Last treibt und am Ausgang zu einer Spannung als Ausgangssignal führt. Allerdings benötigen große Spannungssignale eine entsprechende Gleichspannungs-Aussteuerungsreserve.

Des weiteren ist es erforderlich, daß die Mischer eine wesentlich höhere Eingangsimpedanz aufweisen im Vergleich zur Ausgangsimpedanz der Verstärker, um die Einfügungsdämpfung zu reduzieren. Eine Eingangsstufe mit gemeinsamen Emitter wie beim Verstärker muß in diesem Fall implementiert werden, an die zusätzliche Linearitätsanforderungen aufgrund der Verstärkung des Verstärkers zu stellen sind. Diese Linearität kann erreicht werden durch eine Emitterdegeneration, jedoch erfordert dies beim Mischer eine sehr hohe Ausgangsimpedanz, um eine Spannungsumsetzerverstärkung von annähernd OdB zu erreichen. Dies bedeutet seinerseits wiederum, daß eine höherere Aussteuerungsreserve erforderlich ist. Auch beim Phasenkombinierer treten die gleichen Anforderungen auf und auch er benötigt eine zusätzliche Aussteuerungsreserve. Werden die Blöcke also übereinander gesetzt, dann ist zwar die Stromaufnahme geringer, jedoch wird eine erhebliche Aussteuerungsreserve benötigt, die einen Betrieb bei niedriger Spannung, wie sie bei mobilen Anwendungen benötigt wird (z. B. 2,7 V) nicht zulässt. Andererseits haben Schaltungsanordnungen, bei denen die Blöcke parallel angeordnet sind, eine weitaus höhere Leistungsaufnahme bei ansonsten schlechteren Eigenschaften.

Aufgabe der Erfindung ist es, eine Schaltungsanordnung der eingangs genannten Art anzugeben, die obige Nachteile nicht aufweist.

Die Erfindung wird durch eine Schaltungsanordnung gemäß Patentanspruch 1 gelöst. Ausgestaltungen und Weiterbildungen des Erfindungsgedankens sind Gegenstand von Unteransprüchen.

Die erfindungsgemäße Schaltungsanordnung zum Mischen eines Eingangssignal und eines Oszillatorsignals miteinander weist insbesondere folgende Merkmale auf:
Einen Phasenteiler mit einem Eingang und zwei Spannungs-Ausgängen, bei dem an den Eingang das Oszillatorsignal angelegt ist und an dessen Ausgängen einander gegenüber um 90° phasenverschobene, orthogonale Oszillatorsignale abnehmbar sind;
einen ersten Differenzverstärker mit einem Spannungseingang und einem Stromausgang, dessen Spannungseingang mit einem der zwei Spannungsausgänge des Phasenteilers verbunden ist;
einen zweiten Differenzverstärker mit einem Spannungseingang und einem Stromausgang, dessen Spannungseingang mit dem anderen der zwei Spannungsausgängen des Phasenteilers verbunden ist;
eine erste steuerbare Stromquelle, die zur Versorgung des ersten Differenzverstärkers mit diesem verbunden ist und die durch das Eingangssignal gesteuert wird;
eine zweite steuerbare Stromquelle, die zur Versorgung des zweiten Differenzverstärkers mit diesem verbunden ist und die durch das Eingangssignal gesteuert wird;
einen ersten Phasenschieber mit einem Stromeingang und einem Stromausgang, der dem ersten Differenzverstärker nachgeschaltet ist;
einen zweiten Phasenschieber mit einem Stromeingang und einem Stromausgang, der dem zweiten Differenzverstärker nachgeschaltet ist; und
einer Addiereinrichtung, die erstem und zweitem Differenzverstärker nachgeschaltet ist und ein Ausgangssignal bereitstellt.

Die vorliegende Erfindung ermöglicht es, einzelne Schaltungsblöcke derart übereinander zu stapeln, daß zum einen die Biasströme durch die einzelnen Blöcke geteilt werden können und daß sie zum anderen selbst bei sehr niedrigen Versorgungsspannungen bis herunter zu 2,7 V arbeiten können. Die Mischer haben dabei eine sehr niedrige Eingangsimpedanz (aufgrund der gekoppelten Basen) und werden jeweils mit dem halben Strom (bei dem halben Biasstrompegel des Verstärkers mit geringem Rauschen) gespeist ist. Außerdem wird durch eine derartige Architektur nur ein geringer Spannungsaussteuerungsreserve benötigt. In dem die das Oszillatorsignal verstärkenden Verstärker derart ausgelegt werden, daß die Ausgangsimpedanz klein genug ist, kann der Mischer auf ein einfaches das Oszillatorsignal schaltendes Schalterpaar reduziert werden, welche die Eingangsstufe mit gemeinsamer Basis ersetzt. Der Phasenkombinierer, der auf ähnliche Weise aufgebaut ist, kann dann schließlich noch auf die Mischer draufgesetzt werden und den gleichen Biasstrom erhalten wie die übrigen Schaltungsteile. Da die Biasströme hohe Pegel aufweisen, sind die Eingangsimpedanzen aller Blöcke klein genug, so daß insgesamt ein geringer Signalverlust auftritt. Die Gesamtverstärkung wird im wesentlichen von dem Verstärker mit niedrigem Rauschen erzeugt, um vorteilhafterweise höhere Rauschbeiträge der Mischer aufgrund der Signalaufteilung an ihrem Eingang zu kompensieren. Schließlich kann durch das Übereinanderstapeln des Phasenkombinierers und der Mischer die Leistungsaufnahme der gesamten Anordnung deutlich reduziert werden.

Bei einer Weiterbildung der Erfindung weisen die beiden Phasenschieber jeweils einen symmetrischen Eingang und einen symmetrischen Ausgang mit jeweils einem invertierenden und nicht-invertierenden Anschluß auf. Dabei sind jeweils die eingangsseitigen invertierenden und nicht-invertierenden Anschlüsse mit den ausgangsseitigen invertierenden und nicht-invertierenden Anschlüssen mittels jeweils zweier Widerstände und zweier Kondensatoren direkt bzw. über Kreuz verbunden. Damit läßt sich mit geringem schaltungstechnischen Aufwand und in passiver Schaltungstechnik ein geeigneter Phasenschieberstromein- und ausgang realisieren. Die passive Realisierung hat darüber hinaus den Vorteil, daß im wesentlichen kein zusätzliches Rauschen wie etwa bei aktiven Phasenschiebern entsteht.

Vorzugsweise weisen die steuerbaren Stromquellen eine in Reihe zu dem jeweiligen Differenzverstärker geschaltete erste Konstantstromquelle, eine dem jeweiligen Differenzverstärker parallel geschaltete zweite Konstantstromquelle und eine den ersten Konstantstromquellen parallel geschaltete Verstärkerstufe auf.

Schließlich wird bevorzugt bei Verstärkerstufe und/oder Addiereinrichtung eine Kaskodschaltung vorgesehen, die insbesondere aus einer gemeinsamen Referenzspannungsquelle gespeist wird.

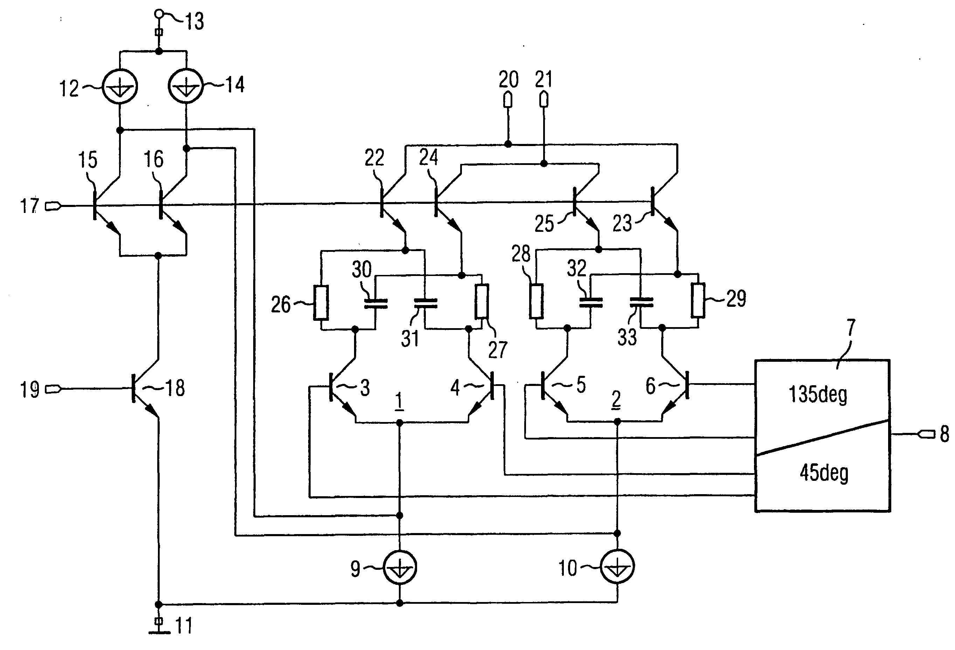

Die Erfindung wird nachfolgend anhand des in der einzigen Figur der Zeichnung dargestellten Ausführungsbeispiels näher erläutert.

Die in der Zeichnung dargestellte erfindungsgemäße Schaltungsanordnung enthält zwei Differenzverstärker 1 und 2, die jeweils zwei emittergekoppelte npn-Bipolartransistoren 3, 4 bzw. 5, 6 aufweisen. Die Basen der Transistoren 3, 4 sind dabei an einen symmetrischen Ausgang eines Phasenteilers 7 angeschlossen, während die Basen der Transistoren 5, 6 an den anderen symmetrischen Ausgang des Phasenteilers 7 angeschlossen sind. An den Phasenteiler 7 ist ein Oszillatorsignal 8 angelegt. An den beiden symmetrischen Ausgängen des Phasenteilers 7 liegen orthogonale Oszillatorsignale an, d. h. zwei zueinander um 90° phasenverschobene Signale, die auf das Oszillatorsignal 8 zurückgehen. Die Phasenverschiebung von 90° wird beim Ausführungsbeispiel dadurch erreicht, daß das Oszillatorsignal zum einen einem Phasenschieber mit einer Phasenverschiebung von 45° und zum anderen einem Phasenschieber mit einer Phasenverschiebung von 135° zugeführt wird. Damit ergibt sich eine Phasendifferenz von 90° zwischen den beiden Signalen am Ausgang der beiden Phasenschieber und damit an den Ausgängen des Phasenteilers 7. Die symmetrischen Ausgänge des Phasenteilers 7 sind Spannungsausgänge zur Ansteuerung der Transistoren 3, 4 bzw. 5, 6.

Die Differenzverstärker 1 und 2 werden durch jeweils eine Konstantstromquelle 9 bzw. 10 gespeist derart, daß die Konstantstromquelle 9 zwischen die gekoppelten Emitter der Transistoren 3 und 4 einerseits und ein Bezugspotential 11 andererseits geschaltet sind und die Konstantstromquelle 10 zwischen die gekoppelten Emitter der Transistoren 5 und 6 einerseits und das Bezugspotential 11 andererseits geschaltet ist. Darüber hinaus sind die gekoppelten Emitter der Transistoren 3 und 4 über eine Konstantstromquelle 12 mit einem positiven Versorgungspotential 13 und die gekoppelten Emitter der Transistoren 5 und 6 über eine Konstantstromquelle 14 ebenfalls mit dem positiven Versorgungspotential 13 verbunden. Darüber hinaus sind die gekoppelten Emitter der Transistoren 3 und 4 bzw. 5 und 6 über eine Kaskodestufe zusammengeführt und mit dem Ausgang einer Verstärkerstufe verbunden. Die Kaskodestufe besteht beim Ausführungsbeispiel aus zwei npn-Bipolartransistoren 15 und 16, deren Basen und Emitter jeweils miteinander verschaltet sind. Die gekoppelten Basen sind dabei an ein Referenzpotential 17 angeschlossen. Die Emitter der Transistoren 15 und 16 sind hierbei jeweils mit den gekoppelten Emittern der Transistoren 3 und 4 bzw. 5 und 6 verbunden. Die gekoppelten Emitter der Transistoren 15 und 16 sind schließlich mit dem Kollektor eines npn-Bipolartransistors 18 verschaltet, dessen Emitter mit dem Bezugspotential 11 und dessen Basis mit einem Eingangssignal 19 beaufschlagt ist. Der Transistor 18 bildet dabei eine Eingangsverstärkerstufe, wirkt aber gleichzeitig in Verbindung mit der Kaskodeschaltung 15, 16, 17 und den Stromquellen 9, 10, 12, 14 als steuerbare Stromquelle für die Differenzverstärker 1 und 2.

Den Stromausgängen der Differenzverstärker 1 und 2 bildenden Kollektoren der Transistoren 3, 4, 5, 6 sind jeweils passive Phasenschieber nachgeschaltet und über die Phasenschieber auf eine Addierstufe geführt. Die als Kombiniereinrichtung wirkende Addierstufe ihrerseits enthält vier Kaskodestufen, deren Ausgänge paarweise zusammengefaßt werden und den symmetrischen Ausgang 20, 21 der erfindungsgemäßen Schaltungsanordnung bilden. Im einzelnen sind die Kollektoren zweier npn-Bipolartransistoren 22 und 23 miteinander sowie mit dem Anschluß 20 verbunden. In gleicher Weise sind auch die Kollektoren zweier npn-Bipolar-Transistoren 24 und 25 miteinander sowie mit dem Ausgangsanschluß 21 verbunden. Die Basen der Transistoren 22, 23, 24, 25 sind miteinander sowie mit dem Referenzpotential 17 verbunden. Die Emitter der Transistoren 22, 24 bzw. 23, 25 stellen die Stromeingänge der Addiereingänge dar, während die Anschlüsse 20 und 21 die symmetrischen Stromeingänge der Biasschaltung sowie der erfindungsgemäßen Schaltungsanordnung bilden.

Die beiden jeweils zwischen die Differenzverstärker 1 und 2 sowie die Addiereinrichtung geschalteten Phasenschieber sind passiv und werden durch ein RC-Netzwerk gebildet. Dazu ist jeweils der Kollektor des Transistors 3 mit dem Emitter des Transistors 22, der Kollektor des Transistors 4 mit dem Emitter des Transistors 24, der Kollektor des Transistors 5 mit dem Emitter des Transistors 25 und der Kollektor des Transistors 6 mit dem Emitter des Transistors 23 über jeweils einen ohmschen Widerstand 26, 27, 28, 29 verbunden. Des weiteren ist der Kollektor des Transistors. 3 mit dem Emitter des Transistors 24, der Kollektor des Transistors 4 mit dem Emitter des Transistors 22, der Kollektor des Transistors 5 mit dem Emitter des Transistors 23 und der Kollektor des Transistors 6 mit dem Emitter des Transistors 25 über jeweils einen Kondensator 30, 31, 32, 33 verbunden.

Die Differenzverstärkerstufen 1 und 2, die jeweiligen Phasenschieber und die Addierstufe in Form einer Kaskodschaltung sind jeweils übereinander gestapelt, d. h. strommäßig in Serie geschaltet. Der Eingangsverstärker dient dabei zum einen zur Verstärkung und zum anderen gleichzeitig zur Steuerung der Biasströme der Differenzverstärkerstufen 1 und 2 und damit zur Multiplikation. Die Konstantstromquellen 9, 10, 12, 14 liefern beim Ausführungsbeispiel jeweils den gleichen Strom.

Die Schaltung zeichnet sich neben einem geringen Aufwand auch durch geringe Biasströme und eine niedrige Betriebsspannung aus. Durch die Stromkopplung ist keine wesentliche Spannungs-Aussteuerungsreserve notwendig und die Impedanzanpassung der einzelnen Stufen untereinander ist nahezu ideal.

## Patentansprüche

1. Schaltungsanordnung zum Mischen eines Eingangssignals und eines Oszillatorsignals miteinander mit:
einem Phasenteiler mit einem Eingang und zwei Spannungs-Ausgängen, bei dem an den Eingang das Oszillatorsignal angelegt ist und an dessen Ausgängen einander gegenüber um 90° phasenverschobene, orthogonale Oszillatorsignale abnehmbar sind;
einem ersten Differenzverstärker mit einem Spannungseingang und einem Stromausgang, dessen Spannungseingang mit einem der zwei Spannungsausgänge des Phasenteilers verbunden ist;
einem zweiten Differenzverstärker mit einem Spannungseingang und einem Stromausgang, dessen Spannungs-Eingang mit dem anderen der zwei Spannungsausgänge des Phasenteilers verbunden ist;
einer ersten steuerbaren Stromquelle, die zur Versorgung des ersten Differenzverstärkers mit diesem verbunden ist und die durch das Eingangssignal gesteuert wird;
einer zweiten steuerbaren Stromquelle, die zur Versorgung des zweiten Differenzverstärkers mit diesem verbunden ist und die durch das Eingangssignal gesteuert wird;
einem ersten Phasenschieber mit einem Stromeingang und einem Stromausgang, der dem ersten Differenzverstärker nachgeschaltet ist;
einem zweiten Phasenschieber mit einem Stromeingang und einem Stromausgang, der dem zweiten Differenzverstärker nachgeschaltet ist; und
einer Addiereinrichtung, die erstem und zweitem Differenzverstärker nachgeschaltet ist und ein Ausgangssignal bereitstellt.

2. Schaltungsanordnung nach Anspruch 1, bei der die Phasenschieber jeweils einen symmetrischen Eingang und einen symmetrischen Ausgang mit jeweils einem invertierenden und nichtinvertierenden Anschluß aufweisen;
wobei jeweils die eingangsseitigen invertierenden und nicht-invertierenden Anschlüsse mit den ausgangsseitigen invertierenden und nicht-invertierenden Anschlüssen mittels jeweils zweier Widerstände und zweier Kondensatoren direkt bzw. über Kreuz verbunden sind.

3. Schaltungsanordnung nach Anspruch 1 oder 2, bei der die steuerbaren Stromquellen jeweils aufweisen:
eine in Reihe zu dem jeweiligen Differenzverstärker geschaltete erste Konstantstromquelle;
eine dem jeweiligen Differenzverstärker parallel geschaltete zweite Konstantstromquelle; und
eine den ersten Konstantstromquellen parallel geschaltete Verstärkerstufe.

4. Schaltungsanordnung nach Anspruch 1, 2 oder 3, bei der die Verstärkerstufe eine Kaskodeschaltung aufweist.

5. Schaltungsanordnung nach Anspruch 1, 2 oder 3, bei der die Addiereinrichtung eine Kaskodeschaltung aufweist.

6. Schaltungsanordnung nach Anspruch 1, 2 oder 3, bei der die Verstärkerstufe und die Addiereinrichtung aus einer gemeinsamen Referenzspannungsquelle gespeiste Kaskodeschaltungen aufweisen.

## Claims

1. Circuit arrangement for mixing an input signal and an oscillator signal with one another, having:
a phase splitter with one input and two voltage outputs; in which the oscillator signal is applied to the input and orthogonal oscillator signals, which are phase-shifted through 90° with respect to one another can be tapped off at its outputs;
a first differential amplifier with one voltage input and one current output, whose voltage input is connected to one of the two voltage outputs of the phase splitter;
a second differential amplifier with one voltage input and one current output, whose voltage input is connected to the other of the two voltage outputs of the phase splitter;
a first controllable current source which is connected to the first differential amplifier in order to supply it and is controlled by the input signal;
a second controllable current source, which is connected to the second differential amplifier in order to supply it and is controlled by the input signal;
a first phase shifter with one current input and one current output, which is connected downstream of the first differential amplifier;
a second phase shifter with one current input and one current output which is connected downstream of the second differential amplifier; and
an adder device which is connected downstream from the first and second differential amplifiers and produces an output signal.

2. Circuit arrangement according to Claim 1, in which the phase shifters each have one balanced input and one balanced output, each having one inverting and one non-inverting connection;
with the input-side inverting and non-inverting connections respectively being connected to the output-side inverting and non-inverting connections, directly and crossed over by means of two resistors and two capacitors in each case.

3. Circuit arrangement according to Claim 1 or 2, in which the controllable current sources each have:
a first constant current source connected in series with the respective differential amplifier; a second constant current source connected in parallel with the respective differential amplifier; and
an amplifier stage connected in parallel with the first constant current sources.

4. Circuit arrangement according to Claim 1, 2 or 3, in which the amplifier stage has a cascode circuit.

5. Circuit arrangement according to Claim 1, 2 or 3, in which the adder device has a cascode circuit.

6. Circuit arrangement according to Claim 1, 2 or 3, in which the amplifier stage and the adder device have cascode circuits which are fed from a common reference voltage source.

## Revendications

1. Circuit pour mélanger un signal d'entrée et un signal d'oscillateur entre eux comprenant :
un diviseur de phases ayant une entrée et deux sorties de tension, dans lequel le signal d'oscillateur peut être appliqué à l'entrée et aux sorties duquel peuvent être prélevés des signaux d'oscillateur orthogonaux déphasés l'un par rapport à l'autre de 90° ;
un premier amplificateur différentiel ayant une entrée de tension et une sortie de courant, dont l'entrée de tension est reliée à l'une des deux sorties de tension du diviseur de phases ;
un deuxième amplificateur différentiel ayant une entrée de tension et une sortie de courant, dont l'entrée de tension est reliée à l'autre des deux sorties de tension du diviseur de phases ;
une première source de courant, qui peut être commandée, qui pour l'alimentation du premier amplificateur différentiel est reliée à celui-ci et qui est commandée par le signal d'entrée ;
une deuxième source de courant, qui peut être commandée, qui pour l'alimentation du deuxième amplificateur différentiel est reliée à celui-ci et qui est commandée par le signal d'entrée ;
un premier déphaseur ayant une entrée de courant et une sortie de courant, qui est monté en aval du premier amplificateur différentiel ;
un deuxième déphaseur ayant une entrée de courant et une sortie de courant, qui est monté en aval du deuxième amplificateur différentiel ; et
un dispositif additionneur qui est monté en aval du premier et du deuxième amplificateurs différentiels et qui donne un signal de sortie.

2. Circuit suivant la revendication 1, dans lequel les déphaseurs ont respectivement une entrée symétrique et une sortie symétrique ayant respectivement une borne inverseuse et une borne non inverseuse ;
les bornes inverseuse et non inverseuse du côté entrée étant reliées directement ou en croix aux bornes inverseuse et non inverseuse du côté sortie au moyen de respectivement deux résistances et deux condensateurs.

3. Circuit suivant la revendication 1 ou 2, dans lequel les sources de courant qui peuvent être commandées comportent respectivement
une première source de courant constant montée en série avec l'amplificateur différentiel respectif ;
une deuxième source de courant constant montée en parallèle avec l'amplificateur différentiel respectif ; et
un étage amplificateur monté en parallèle aux premières sources de courant constant.

4. Circuit suivant la revendication 1, 2 ou 3, dans lequel l'étage amplificateur comprend un circuit cascode.

5. Circuit suivant la revendication 1, 2 ou 3, dans lequel le dispositif additionneur comporte un circuit cascode.

6. Circuit suivant la revendication 1, 2 ou 3, dans lequel l'étage amplificateur et le dispositif additionneur comportent des circuits cascodes alimentés par une source commune de tension de référence.
